Europäisches Patentamt

European Patent Office

Office européen des brevets

(19)

(11) Numéro de publication: **0 080 395**
**B1**

(12) # FASCICULE DE BREVET EUROPEEN

(45) Date de publication du fascicule du brevet:
**24.07.85**

(51) Int. Cl.⁴: **H 03 K 3/356**

(21) Numéro de dépôt: **82402025.9**

(22) Date de dépôt: **03.11.82**

(54) Bascule bistable à stockage non volatil et à repositionnement dynamique.

(30) Priorité: **20.11.81 FR 8121802**

(43) Date de publication de la demande:
**01.06.83 Bulletin 83/22**

(45) Mention de la délivrance du brevet:
**24.07.85 Bulletin 85/30**

(84) Etats contractants désignés:
**CH DE FR GB IT LI NL**

(56) Documents cités:
**DE - A - 2 622 307**
**US - A - 4 128 773**
**US - A - 4 207 615**

**PROCEEDINGS OF THE IEEE, vol. 58, no. 8, août 1970, pages 1207-1219, New York (USA);**
**FROHMANN-BENTCHKOWSKY: "The metal-nitride-oxide-silicon (MNOS) transistor-characteristics and applications"**

(73) Titulaire: **SOCIETE POUR L'ETUDE ET LA FABRICATION DE CIRCUITS INTEGRES SPECIAUX - E.F.C.I.S.,**
**17, avenue des Martyrs, F-38100 Grenoble (FR)**

(72) Inventeur: **Brice, Jean-Michel, THOMSON-CSF**
**SCPI 173, bld Haussmann, F-75379 Paris Cedex 08 (FR)**

(74) Mandataire: **de Beaumont, Michel et al, THOMSON-CSF**
**SCPI 173, Bld Haussmann, F-75379 Paris Cedex 08 (FR)**

ACTORUM AG

**Description**

La présente invention concerne le domaine des circuits de sauvegarde et plus particulièrement une bascule bistable dont le contenu, à un instant donné, peut être stocké de façon non volatile dans des éléments de stockage, la bascule pouvant être ensuite repositionnée selon les informations stockées.

La présente invention permet la mémorisation des informations contenues dans une bascule bistable pour le cas où l'alimentation de cette bascule viendrait à s'interrompre, puis le repositionnement de cette bascule une fois que la tension d'alimentation est rétablie.

On s'intéressera ici essentiellement aux structures de types MOS, c'est-à-dire à des structures à effet de champ à grille conductrice (par exemple un métal M) formée sur une couche isolante (par exemple un oxyde O) au-dessus d'un semiconducteur (S).

On connaît déjà de telles bascules avec sauvegarde de l'état, d'après les brevets US-A 4 128 773 et DE-A 2 622 307.

La présente invention propose une bascule bistable améliorée, ayant un circuit de sauvegarde, visant à satisfaire notamment aux caractéristiques suivantes:
— sûreté de fonctionnement et, notamment:
  • inscription dans des éléments de stockage non volatil à partir de l'état de la bascule bistable toujours possible dans tous les cas de fonctionnement,
  • repositionnement correct du bistable lors de sa remise sous tension à partir de l'état des éléments de stockage non volatil et seulement sur un ordre précis,
  • non perturbation du bistable par les éléments de stockage en dehors de la phase de repositionnement,
— facilité d'utilisation:
  • réduction du nombre de commandes particulières nécessaires pour la fonction de sauvegarde,
  • rapidité des séquences de prise en mémoire et de repositionnement, en particulier en ce qui concerne la mémorisation qui doit être la plus courte possible.

Pour satisfaire ces diverses exigences, la présente invention prévoit une bascule à laquelle est adjoint un circuit de sauvegarde lui permettant d'avoir une fonction de stockage non volatil, la commande des opérations de mise en mémoire, de stockage et de repositionnement pouvant être effectuée à l'aide d'une seule ligne de commande.

Pour atteindre ces objets, la présente invention prévoit une bascule à stockage non volatil constituée d'une bascule bistable classique à transistors MOS (T1 à T4) comportant des noeuds Q et Q* et connectée entre un potentiel d'alimentation (VCC) et un potentiel de référence (M), et une ou deux branches de stockage comprenant un élément de stockage non volatil (TM1, TM2) du type transistor MOS à tension de seuil programmable électriquement, l'une des borne principales et la borne de commande de chaque élément de stockage de la première branche étant connectées respectivement au noeud Q ou Q*,

et des moyens pour modifier le potentiel d'alimentation (VCC) entre un premier niveau propre à conditionner les éléments de stockage et leur faire mémoriser l'état précédent de la bascule, caractérisée en ce que chaque branche de stockage comporte une capacité reliée entre l'autre borne principale de l'élément de stockage et le potentiel d'alimentation et en ce que les moyens pour modifier le potentiel d'alimentation sont aptes à faire passer brutalement le potentiel d'alimentation d'une valeur nulle à celle du premier niveau dans une phase de repositionnement, ce qui assure le repositionnement dynamique de la bascule dans un état précédemment mémorisé par les éléments de stockage.

La bascule bistable classique peut par exemple être du type à transistors MOS complémentaires ou à transistors MOS enrichis et déplétés. Les éléments de stockage peuvent être des transistors MNOS (métal-niture-oxyde-semiconducteur) dont le substrat est relié à la source. Ces éléments de stockage peuvent aussi être du type à grille flottante. Pour permettre le fonctionnement de la bascule non volatile selon l'invention dans ses quatre phases, à savoir fonctionnement normal indépendamment de tout stockage, mémorisation, stockage et repositionnement, le potentiel d'alimentation peut varier entre un premier niveau propre à assurer le fonctionnement de la bascule classique et un deuxième niveau propre à conditionner l'élément de stockage. Ce potentiel d'alimentation est également susceptible d'être interrompu, c'est pourquoi l'on prévoit un stockage non volatil.

Pendant les phases de fonctionnement normal, de mise en mémoire et de stockage, les transistors de la tension d'alimentation sont lentes devant les constantes de temps liées aux branches de stockage et les capacités agissent comme des interrupteurs ouverts. Enfin, pendant les périodes de repositionnement, le signal d'alimentation est rétabli rapidement à son premier niveau et les capacités fonctionnent en régime transistoire comme des interrupteurs fermés.

Selon un avantage de la présente invention, on notera que les éléments de stockage sont amenés à subir un cycle de fonctionnement seulement aux instants où l'on souhaite mémoriser le contenu de la bascule. Il n'y a pas de changement d'état de ces éléments à chaque changement d'état de la bascule. Cette caractéristique est importante, notamment quand on utilise des éléments de stockage du type transistors MNOS étant donné que le nombre de cycles de fonctionnement de tels transistors MNOS est limité à des valeurs de l'ordre de $10^6$ à $10^8$ cycles.

La présente invention présente également les avantages exposés précédemment dans l'énoncé de ses objets auxquels il convient d'ajouter que la prise en mémoire se fait de façon particulièrement simple et rapide, en un seul cycle de commande sous l'effet de la variation de la tension d'alimentation.

Ces objets, caractéristiques et avantages ainsi que d'autres de la présente invention seront exposés plus en détail dans la description suivante de modes de réalisation particuliers faite en relation avec les figures jointes parmi lesquelles:

la figure 1 représente sous forme schématique et généralisée une bascule selon la présente invention,

la figure 2 représente un premier mode de réalisation d'un dispositif selon l'invention dans lequel la bascule classique est à transistors MOS complémentaires,

la figure 3 représente un schéma équivalent du circuit de la figure 2 en régime dynamique,

la figure 4 représente la tension d'alimentation appliquée au dispositif lors de ses diverses phases de fonctionnement,

la figure 5 représente un deuxième mode de réalisation d'un dispositif selon l'invention dans lequel la bascule bistable est asymétrique,

la figure 6 représente un schéma équivalent du circuit de la figure 5 en régime dynamique,

la figure 7 représente un troisième mode de réalisation d'un dispositif selon l'invention dans lequel la bascule classique est à transistors MOS enrichis/déplétés.

Dans les diverses figures représentant des bascules bistables, les conducteurs et les périphériques d'accès aux bascules vers les noeuds Q et Q* n'ont pas été figurés. Ils seront réalisés de façon classique.

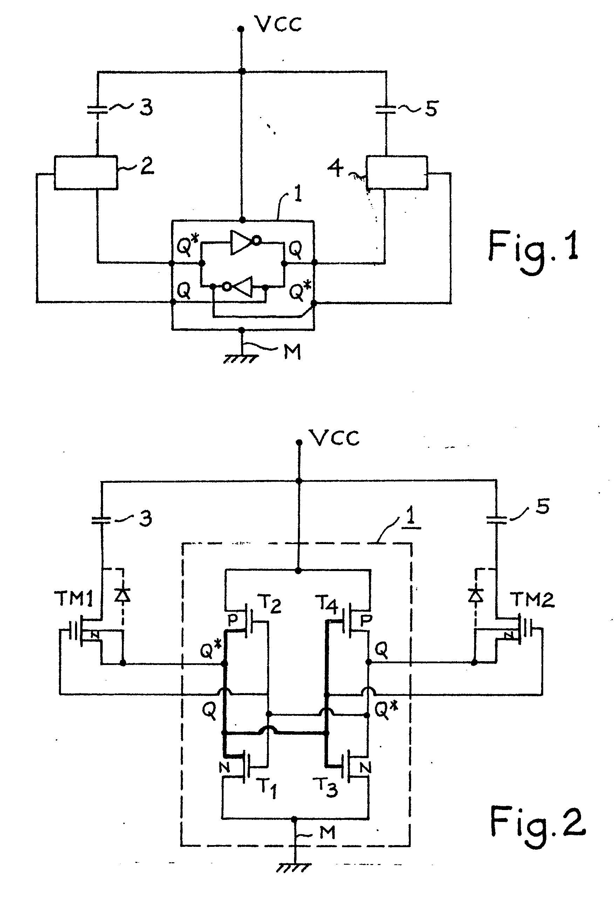

La figure 1 représente de façon générale et schématique le circuit selon la présente invention. Ce circuit comprend une bascule bistable classique présentant des bornes ou noeuds complémentaires Q et Q* qui peuvent chacune prendre l'un ou l'autre de deux états logiques, mais jamais le même état. Cette bascule est connectée entre une source d'alimentation VCC, couramment 5 volts, et une tension de référence M, couramment la masse. Ainsi, en fait, les deux états logiques Q et Q* correspondent à la tension VCC ou au potentiel de la masse. Pour le fonctionnement normal d'une bascule, le potentiel VCC est couramment de l'ordre de 5 volts.

On suppose ici que la bascule 1 est de type volatil ou non rémanent, c'est-à-dire qu'en cas d'interruption du potentiel VCC, le dernier état qu'a atteint la bascule est perdu. Pour remédier à cet état de choses et créer une sauvegarde de la dernière information mémorisée avant la coupure du courant, il est prévu d'adjoindre à la bascule deux branches de stockage comprenant chacune un élément de stockage, respectivement 2 et 4, et une capacité, respectivement 3 et 5. Ces deux branches sont disposées entre l'une des sorties de la bascule et la tension d'alimentation VCC. Les éléments de stockage 2 et 4 sont des transistors MOS à deux tensions de seuil programmables électriquement comprenant deux bornes principales et une borne de commande. La borne de commande est reliée au noeud de la bascule complémentaire de celui auquel est connectée l'une des bornes principales.

Pour effectuer une opération de sauvegarde, c'est-à-dire de conditionnement des éléments de stockage 2 et 4, on procède à une élévation de la tension d'alimentation VCC juste avant une coupure de cette alimentation. En cas de coupure volontaire de la tension d'alimentation, ceci est facile à réaliser. En cas de coupure accidentelle de la tension d'alimentation, on connaît des circuits pour fournir pendant une courte durée une telle tension haute dès que l'on détecte une baisse de la tension normale d'alimentation, la source de tension haute pouvant par exemple consister en des capacités tampons normalement alimentées pendant le fonctionnement normal du dispositif. Ainsi, à l'instant de l'application de la tension haute, un potentiel élevé se trouve appliqué entre les noeuds Q et Q* de la bascule et agit de façon inverse entre la borne de commande et l'une des bornes principales pour chacun des éléments de stockage 2 et 4. Ceci, à condition que la tension de seuil de programmation des éléments de stockage soit supérieure à la tension de fonctionnement normal de la bascule, ce qui est généralement le cas dans les dispositifs classiques, permet de conditionner les éléments de stockage 2 et 4 dans des états complémentaires. La façon dont l'état mémorisé dans les éléments de stockage 2 et 4 est utilisé pour repositionner la bascule lors de la réalimentation du dispositif sera exposée en détail ci-après en relation avec la description d'un mode de réalisation particulier de la présente invention en vue de simplifier la description.

Des éléments de stockage répondant à la définition générale de «transistors MOS à tension de seuil programmable électriquement» sont par exemple des cellules MNOS (métal nitrure oxyde semiconducteur) ou des transistors à grille flottante comme, par exemple, ceux désignés couramment dans la technique sous l'appellation transistors Flotox. Dans la pratique, on choisira comme éléments de stockage 2 et 4 des éléments réalisables dans une technologie compatible avec celle selon laquelle est réalisée la bascule bistable 1. Par exemple, si l'on utilise des transistors à grille flottante de type Flotox, il semble à l'heure actuelle que la technologie de bascule la plus simplement compatible soit la technologie MOS à canal N enrichi/déplété. Avec une technologie de type MNOS pour les éléments de stockage, la réalisation d'une bascule MOS de type à transistors complémentaires (CMOS) semble aujourd'hui l'une des plus compatibles. C'est ce mode de réalisation particulier qui va être décrit ci-après à titre d'exemple, et qui va être utilisé pour fournir une description détaillée du procédé de fonctionnement de la bascule bistable à stockage non volatil et à repositionnement dynamique selon l'invention.

Dans le mode de réalisation particulier représenté en figure 2, la bascule 1 est à transistors MOS complémentaires. Elle comprend quatre transistors T1 à T4, les transistors T1 et T3 étant à canal N et les transistors T2 et T4 à canal P. Les transistors T1 et T2 sont placés en série entre la masse et le potentiel d'alimentation VCC, de même que les transistors T3 et T4. Les grilles des transistors T1 et T2 sont connectées au point de jonction source/drain des transistors T3 et T4 et les grilles des transistors T3 et T4 sont connectées au point de jonction source/drain des transistors T2 et T1. On appelle Q* la borne correspondant à la connexion des grilles des transistors T3 et T4 et Q la borne correspondant à la connexion des grilles des transistors T1 et T2.

Le fonctionnement de cette bascule, bien connue en elle-même, ne sera pas décrit en détail ici. A cette bascule sont adjointes selon l'invention deux branches de stockage. La première branche connectée au noeud Q* comprend un élément MNOS TM1 en série

avec une capacité 3 dont l'autre borne est reliée à la tension d'alimentation VCC. De même, la deuxième branche connectée entre le noeud Q et le potentiel d'alimentation VCC comprend un élément MNOS TM2 et une capacité 5. La grille de l'élément de stockage MNOS TM1 est connectée au noeud Q et celle de l'élément TM2 au noeud Q*. La source et le substrat des transistors TM1 et TM2 sont interconnectées et reliées comme cela a déjà été exposé aux noeuds Q* et Q. On a figuré en pointillés, bien que cela ne soit pas essentiel à l'exposé de la présente invention, entre les bornes de substrat et de drain des transistors TM1 et TM2, des diodes de fuite parasites inhérentes à la réalisation de ces éléments.

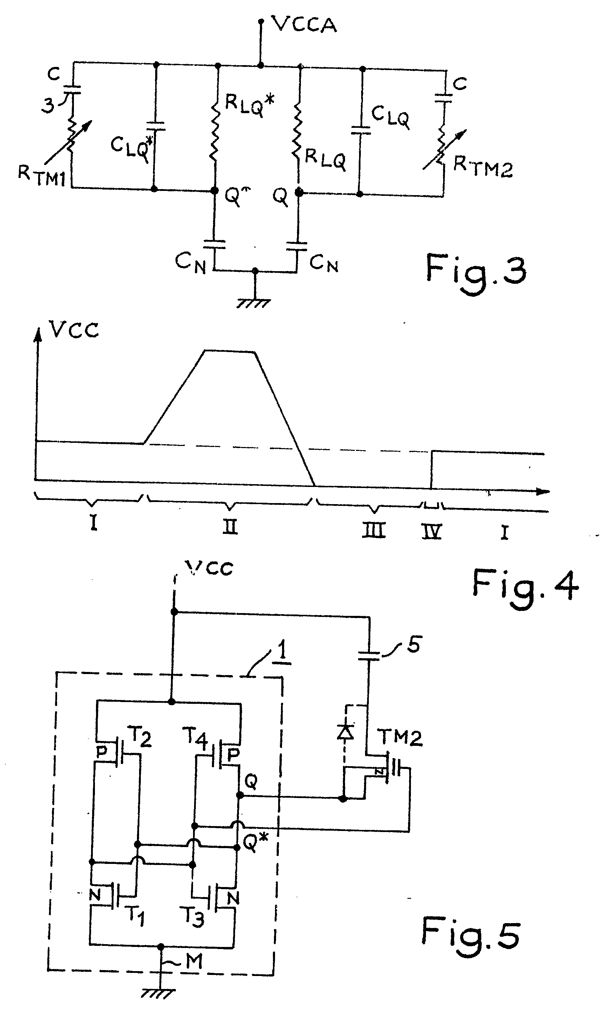

La figure 3 représente un schéma équivalent en régime dynamique du circuit de la figure 2. On peut voir entre la borne VCC et la borne de référence M, un ensemble de condensateurs et de résistances correspondant aux capacités équivalentes à celles des divers éléments. Les capacités 3 et 5 ont des valeurs C, par exemple des valeurs comprises entre quelques dixièmes de pF et quelques pF. Les éléments MNOS ont des résistances équivalentes $R_{TM1}$ et $R_{TM2}$ qui sont fortes (plusieurs centaines de mégohms) quand ces dispositifs sont conditionnés à un état bloquant et faibles (quelques kilohms) quand ces dispositifs sont conditionnés à un état passant. Les transistors T2 et T4 de la bascule, que l'on peut également considérer comme des éléments de charge, ont des impédances équivalentes désignées par $C_{LQ*}$, et $R_{LQ*}$ ou $R_{LQ}$ et $C_{LQ}$ selon que l'on considère le transistor T2 connecté à la borne Q* ou le transistor T4 connecté à la borne Q. En fait, dans le cas d'un montage symétrique tel qu'illustré, on aura sensiblement: $R_{LQ} = R_{LQ*}$ et $C_{LQ} = C_{LQ*}$. Les transistors à canal N T1 et T3 sont illustrés sous forme de condensateurs équivalents de valeur $C_N$.

On va maintenant décrire le fonctionnement du dispositif en relation avec la figure 4 qui représente l'évolution de la tension appliquée à la borne d'alimentation VCC.

Dans une phase I de fonctionnement normal, la tension VCC est la tension normale de fonctionnement de la bascule, par exemple 5 volts. Dans cette configuration, la tension appliquée entre grille et source-substrat des éléments TM1 et TM2 est de plus ou moins 5 volts, c'est-à-dire insuffisante pour changer l'état de seuil de ces éléments. La seule influence des branches de stockage sur le fonctionnement de la bascule réside dans la charge capacitive supplémentaire imposée aux noeuds Q et Q* par la présence des éléments MNOS. Selon une caractéristique importante de l'invention, on notera que la différence de potentiel de l'ordre de 5 volts infligée aux éléments MNOS pendant les changements d'état de la bascule qui, comme on l'a vu, n'entraîne pas une programmation de ces éléments, ne produit pas de phénomène de vieillissement pour ces éléments. La bascule bistable peut donc basculer un nombre illimité de fois dans ces conditions.

Dans l'étape II de prise en mémoire, le potentiel à la borne VCC est porté momentanément à un niveau élevé par rapport au potentiel de référence, propre à agir sur les tensions de seuil des éléments MNOS, ce potentiel étant par exemple de 18 volts. Dans cet état, les éléments MNOS TM1 et TM2 voient entre leur grille et leur source-substrat, une tension de plus ou moins 18 volts. Plus spécifiquement, en supposant que Q* est à haut niveau et Q à bas niveau dans le dernier état de la bascule, l'élément TM1 voit 0 volt sur sa grille et 18 volts sur sa source et son substrat alors que l'élément TM2 reçoit une tension de 18 volts sur sa grille et une tension de 0 volt sur sa source et son substrat. En conséquence, l'élément TM1 se trouve programmé à sa tension de seuil basse et l'élément TM2 acquiert une tension de seuil haute. Ainsi, pour une tension grille source nulle, l'élément TM1 se trouve dans un état déplété, c'est-à-dire qu'il est conducteur (faible impédance) entre son drain et sa source alors que l'élément TM2 se trouve dans un état enrichi, c'est-à-dire qu'il est bloqué (haute impédance) entre son drain et sa source. Cette phase de mémorisation se déroule sans circulation de courant statique du fait de la présence des capacités 3 et 5, c'est-à-dire que la consommation du circuit reste très faible. Bien entendu, la transition de tension d'alimentation de 5 à 18 V sera rapide, mais pas assez pour faire intervenir un courant dynamique circulant par les capacités 3 et 5.

Après cette phase de mise en mémoire, on peut repasser directement en fonctionnement normal, l'état stocké dans les éléments MNOS permettant éventuellement de repositionner ultérieurement la bascule à son état existant à l'instant de la mémorisation. Mais couramment, la phase de mise en mémoire est suivie d'une phase III de stockage pendant laquelle la tension d'alimentation VCC est nulle ou flottante. A nouveau la transition de tension de 18 à 0 ou 5 V se fera de façon à rendre négligeable l'influence d'un régime dynamique.

Pour repositionner ensuite la bascule, comme cela est représenté dans la phase IV de la figure 3, un potentiel d'alimentation VCC est réappliqué très brutalement.

Sur le schéma équivalent, on a alors dans cette configuration $R_{TM1}$ = quelques kilohms, $R_{TM2}$ = quelques centaines de mégohms, $C_{LQ} = C_{LQ*}$ de l'ordre de 0,01 pF, $R_{LQ} = R_{LQ*}$ de l'ordre de quelques kilohms et $C_N$ de l'ordre de 0,1 pF. Etant donné la forte valeur de $R_{TM2}$, on peut considérer que la capacité 5 du côté du noeud Q est hors service. Ainsi, en réponse à une variation dVCC de la tension d'alimentation, les variations résultantes $dV_{Q*}$ et $dV_Q$ seront les suivantes:

$$dV_Q = dVCC \frac{C_L}{C_N + C_L} \quad \# \quad dVCC \frac{C_L}{C_N}$$

$$dV_{Q*} = dVCC \frac{C + C_L}{C + C_N + C_L} \quad \# \quad dVCC$$

Avec le choix indiqué précédemment des valeurs relatives de C, $C_N$ et $C_L$, à savoir $C > C_N > C_L$, on a donc que $V_{Q*}$ varie sensiblement comme VCC alors que $V_Q$ varie peu. En conséquence, la bascule bistable se positionnera dans l'état où $V_{Q*}$ est voisin de VCC tandis que $V_Q$ reste au potentiel de référence, ce qui correspond bien à l'état logique mémorisé initialement.

Pour obtenir ce résultat, il faut que l'on soit effectivement en régime dynamique, c'est-à-dire que le front de montée de la tension VCC soit suffisamment raide pour que les effets capacitifs soient prépondérants. En d'autres termes, le temps de montée de VCC doit être très inférieur aux constantes de temps $R_L$, $C_N$ et $R_{TM1}$ ($C + C_N$). Avec les valeurs numériques exposées précédemment, on notera que ces constantes de temps sont de l'ordre de la microseconde.

D'un point de vue technologique, le schéma indiqué pour le dispositif en figure 2 peut être réalisé en technologie CMOS sur substrat massif ou sur substrat isolant. Dans le cas d'un substrat isolant, les transistors sont naturellement isolés les uns des autres. Par contre, sur un substrat massif, les transistors à canal N T1 et T3 ainsi que les éléments MNOS à canal N TM1 et TM2 sont implantés dans des caissons de type P. Ces caissons sont reliés soit à la masse du circuit, soit à la source des transistors à canal N qu'ils contiennent comme cela est représenté dans la figure. La diode parasite caisson/substrat n'intervient que par sa capacité de jonction car sa tenue en tension est rès supérieure aux tensions appliquées et son courant de fuite négligeable.

Jusqu'à présent, on a décrit une bascule bistable associée à deux branches de stockage lui permettant d'avoir une fonction de bascule non volatile. La bascule classique décrite précédemment était du type symétrique et devait d'ailleurs avoir un fonctionnement aussi symétrique que possible pour pouvoir fonctionner de façon satisfaisante même quand la distance entre les deux seuils des éléments de stockage TM1 et TM2 se réduit tandis que ces dispositifs vieillissent. Il serait également possible de prévoir une bascule bistable a priori dissymétrisée, c'est-à-dire se repositionnant automatiquement sur un certain état en l'absence de branches de stockage, et d'associer à une telle bascule dissymétrique une branche de stockage unique permettant de la repositionner dynamiquement dans son autre état quand l'élément de stockage associé à cette bascule se trouve dans son état de faible impédance. Le mode de commande d'une telle bascule dissymétrique est identique à ce qui a été décrit précédemment. L'avantage de cette structure réside dans la réduction de la surface de silicium utilisée, mais l'inconvénient est que la bascule bistable dissymétrique est moins sensible qu'une bascule symétrique, ce qui signifie notamment qu'elle exige pour son fonctionnement une plus grande différence entre l'état bloqué et l'état conducteur de l'élément MNOS, c'est-à-dire une plus grande fenêtre mémoire.

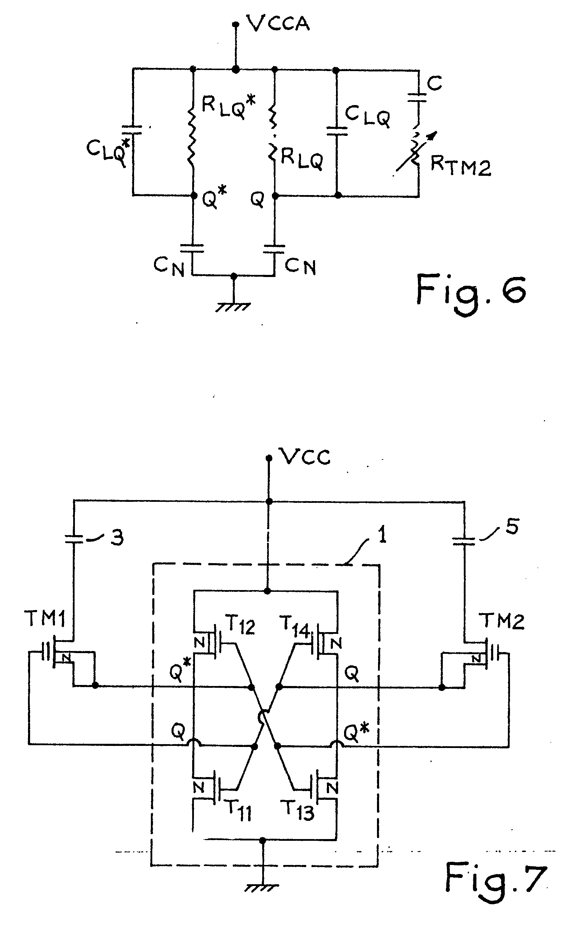

Les figures 5 et 6 représentent respectivement sous forme de schéma de circuit et sous forme de circuit équivalent en régime dynamique un tel montage dissymétrique. La branche de stockage comprenant la capacité 3 et l'élément de stockage TM1 a été supprimé. La bascule est dissymétrisée pour que, quand l'élément de stockage TM2 présente une forte impédance, un repositionnement automatique se fasse avec un état 0 sur le noeud Q*. La branche de stockage restante permet de privilégier un repositionnement sur un état 0 au niveau du noeud Q quand un tel état a été mémorisé. Pour obtenir ce résultat, il convient comme précédemment que C soit plus grand que $C_N$ et $C_{N^*}$, ces valeurs étant elles-mêmes supérieures à $C_{LQ^*}$ et $C_{LQ}$, mais en outre, une dissymétrie doit être créée en prévoyant $R_{LQ^*}$ plus petit que $R_{LQ}$, $C_{NQ}$ plus grand que $C_{NQ^*}$, $C_{LQ^*}$ plus grand que $C_{LQ}$.

Pour assurer cette dissymétrie et les relations ci-dessus, on pourra prévoir des transistors T1 et T2 de surface supérieure à celle des transistors T3 et T4.

La figure 7 représente un autre mode de réalisation de la présente invention dans lequel la bascule symétrique classique 1 est réalisée non plus au moyen de transistors MOS complémentaires, mais au moyen d'une association de transistors MOS enrichis/déplétés. Cette bascule comprend quatre transistors à canal N T11 à T14. Les transistors T11 et T12 sont en série ainsi que les transistors T13 et T14. Les transistors T11 et T13 sont du type à enrichissement, c'est-à-dire normalement non conducteurs, et les transistors T12 et T14 sont du type à déplétion, c'est-à-dire normalement conducteurs. Les grilles des transistors T12 et T13 sont connectées entre elles et à la connexion drain/source des transistors T11 et T12. Les grilles des transistors T11 et T14 sont connectées entre elles et à la connexion drain/source des transistors T13 et T14.

Les branches de stockage et les éléments de stockage sont connectés de la même façon que cela a été décrit précédemment en relation avec la figure 2. La bascule bistable 1 illustrée en figure 7 est connue en elle-même. Elle a été décrite ici seulement pour souligner que la présente invention n'est pas limitée à une utilisation avec un type de bascule particulier. On notera que, dans le cas où l'on choisit une technologie de bascule classique à transistors à canal N enrichis/déplétés, les ressources technologiques habituelles permettent d'associer simplement une telle bascule avec des transistors à grille flottante comme éléments de stockage TM1 et TM2.

Les diverses variantes exposées précédemment ne sont que des exemples de modifications qui peuvent être apportées au schéma de base illustré de façon particulière en figure 2 et de façon plus générale en figure 1. Bien entendu, d'autres variantes peuvent être prévues sans sortir du domaine de la présente invention et, notamment, les diverses variantes illustrées peuvent être combinées.

## Revendications

1. Bascule bistable à stockage non volatil constituée d'une bascule bistable classique à transistors MOS (T1 à T4) comportant des noeuds Q et Q* et connectée entre un potentiel d'alimentation (VCC) et un potentiel de référence (M), et une ou deux branches de stockage comprenant un élément de stockage non volatil (TM1, TM2) du type transistor MOS à tension de seuil programmable électriquement, l'une des bornes principales et la borne de commande de chaque élément de stockage de la première branche étant connectées respectivement au noeud Q ou Q*, et des moyens pour modifier le potentiel d'alimentation (VCC) entre un premier niveau permettant le fonctionnement normal de la bascule, et un deuxième niveau propre à conditionner les éléments de stockage et leur faire mémoriser l'état précédent de la bascule, caractérisée en ce que chacune des branches de stockage comporte une capacité reliée entre l'autre borne principale de l'élément de stockage et le potentiel d'alimentation et en ce que les moyens pour modifier le potentiel d'alimentation sont aptes à faire passer brutalement le potentiel d'alimentation d'une valeur nulle à celle du premier niveau dans une phase de repositionnement, ce qui assure le repositionnement dynamique de la bascule dans un état précédemment mémorisé par les éléments de stockage.

2. Bascule bistable à stockage non volatil selon la revendication 1, caractérisée en ce que la bascule bistable classique est du type à transistors complémentaires.

3. Bascule bistable à stockage non volatil selon la revendication 1, caractérisée en ce que la bascule bistable classique est du type à transistors enrichis et déplétés.

4. Bascule bistable à stockage non volatil selon l'une des revendications 1 ou 2, caractérisée en ce que les éléments de stockage sont de type MNOS, leur substrat étant relié à leur source.

5. Bascule bistable à stockage non volatil selon l'une des revendications 1 ou 3, caractérisée en ce que les éléments de stockage sont des éléments MOS du type à grille flottante.

6. Bascule bistable à stockage non volatil selon l'une quelconque des revendications 1 à 5, caractérisée en ce qu'elle comprend deux branches de stockage, la bascule bistable étant de type symétrique.

7. Bascule bistable selon l'une quelconque des revendications 1 à 5, caractérisée en ce qu'elle comprend une seule branche de stockage raccordée à l'un des noeuds (ou Q ou Q*) de la bascule bistable, les éléments de la bascule bistable raccordés à l'autre noeud de cette bascule par leur connexion drain/source occupant une surface de silicium plus importante que celle des éléments connectés au premier noeud.

**Patentansprüche**

1. Bistabile nichtflüchtige Speicherschaltung, gebildet aus einer herkömmlichen bistabilen Kippschaltung mit MOS-Transistoren (T1 bis T4), die Knotenpunkte Q und Q* umfasst und zwischen ein Versorgungspotential (VCC) und ein Referenzpotential (M) geschaltet ist, und aus einem oder zwei Speicherzweigen, die ein nichtflüchtiges Speicherelement (TM1, TM2) vom MOS-Transistortyp mit elektrisch programmierbarer Schwellspannung umfassen, wobei einer der Hauptanschlüsse und der Steueranschluss jedes Speicherelementes des ersten Zweiges mit dem Knotenpunkt Q oder mit dem Knotenpunkt Q* verbunden ist, und mit Einrichtungen zum Verändern des Versorgungspotentials (VCC) zwischen einem ersten Pegel, der den Normalbetrieb der Kippschaltung gestattet, und einem zweiten Pegel, der geeignet ist, um die Speicherelemente zu konditionieren und sie zur Speicherung des vorausgehenden Zustandes der Kippschaltung zu veranlassen, dadurch gekennzeichnet, dass jeder der Speicherzweige eine Kapazität umfasst, die zwischen den anderen Hauptanschluss des Speicherelementes und das Versorgungspotential geschaltet ist, und dass die Einrichtungen zur Veränderung des Versorgungspotentials geeignet sind, um das Versorgungspotential abrupt von einem Wert Null auf den Wert des ersten Pegels in einer Neueinstellphase zu verändern, was die dynamische Neueinstellung der Kippschaltung in einen Zustand gewährleistet, den die Speicherelemente zuvor gespeichert hatten.

2. Nichtflüchtige bistabile Speicherschaltung nach Anspruch 1, dadurch gekennzeichnet, dass die herkömmliche bistabile Kippschaltung vom Typ mit komplementären Transistoren ist.

3. Nichtflüchtige bistabile Speicherkippschaltung nach Anspruch 1, dadurch gekennzeichnet, dass die herkömmliche bistabile Kippschaltung vom Typ mit angereicherten und verarmten Transistoren ist.

4. Nichtflüchtige bistabile Speicherschaltung nach Anspruch 1 oder 2, dadurch gekennzeichnet, dass die Speicherelemente MNOS-Typen sind, deren Substrat mit ihrer Source-Elektrode verbunden ist.

5. Nichtflüchtige bistabile Speicherschaltung nach einem der Ansprüche 1 und 3, dadurch gekennzeichnet, dass die Speicherelemente MOS-Elemente vom Typ mit schwimmendem Gate sind.

6. Nichtflüchtige bistabile Speicherschaltung nach einem der Ansprüche 1 bis 5, dadurch gekennzeichnet, dass sie zwei Speicherzweige umfasst, wobei die bistabile Kippschaltung vom symmetrischen Typ ist.

7. Bistabile Kippschaltung nach einem der Ansprüche 1 bis 5, dadurch gekennzeichnet, dass sie einen einzigen Speicherzweig aufweist, der an einen der Knotenpunkte (entweder Q oder Q*) der bistabilen Kippschaltung angeschlossen ist, wobei die Elemente der bistabilen Kippschaltung, die mit dem anderen Knotenpunkt dieser Kippschaltung über ihre Drain/Source-Verbindung angeschlossen sind, eine grössere Siliziumoberfläche einnehmen als die mit dem ersten Knotenpunkt verbundenen Elemente.

**Claims**

1. Non-volatile storage bistable latch constituted by a conventional bistable latch with MOS transistors (T1 to T4) comprising nodal points Q and Q* and connected between a supply potential (VCC) and a reference potential (M), and one or two storage branches comprising a non-volatile storage element (TM1, TM2) of the MOS transistor type with electrically programmable threshold voltage, one of the main terminals and the control terminal of each storage element of the first branch being connected to the nodal point Q or to the nodal point Q*, and means for varying the supply potential (VCC) between a first level permitting the normal operation of the latch and a second level able to condition the storage elements and make them memorize the preceding state of the latch, characterized in that each of the storage branches comprises a capacitance connected between the other main terminal of the storage element and the supply potential and that the means for varying the supply potential are adapted to vary the supply potential abruptly from a value zero to the value of the first level in a repositioning phase, which insures the dynamic repositioning of the latch to a state previously memorized by the storage elements.

2. Non-volatile storage bistable latch according to claim 1, characterized in that the conventional bistable latch is of the type with complementary transistors.

3. Non-volatile storage bistable latch according to claim 1, characterized in that the conventional bistable latch is of the type with enhancement or depletion transistors.

4. Non-volatile storage bistable latch according to claim 1 or 2, characterized in that the storage elements are MNOS types, their substrate being connected to their source electrode.

5. Non-volatile storage bistable latch according to one of claims 1 and 3, characterized in that the storage elements are MOS elements of the type with floating gate.

6. Non-volatile storage bistable latch according to any one of claims 1 to 5, characterized in that it comprises two storage branches, the bistable latch being of the symmetric type.

7. Bistable latch according to any one of claims 1 to 5, characterized in that it comprises a single storage branch connected to one of the nodal points (either Q or Q*) of the bistable latch, the elements of the bistable latch connected to the other nodal point of said latch by their drain/source connection occupying a greater silicon surface than that of the elements connected to the first nodal point.

Fig.1

Fig.2

Fig.3

Fig.4

Fig.5

Fig. 6

Fig. 7

13